# EUROPÄISCHE PATENTSCHRIFT

(11) **EP 2 156 566 B1**
(45) Veröffentlichungstag und Bekanntmachung des Hinweises auf die Patenterteilung: **03.06.2015**
(21) Anmeldenummer: 07856817.7
(22) Anmeldetag: 17.12.2007
(51) Int. Cl.: H03M 13/15, H03M 13/35, H04H 20/42, H04H 60/07, H04N 21/236, H04N 21/434

(54) **VERFAHREN UND SENDEVORRICHTUNG MIT ADAPTION DER CODIERUNGSDATEN AN DIE PROGRAMMDATEN**
METHOD AND TRANSMISSION DEVICE WITH ADAPTATION OF THE CODING DATA TO THE PROGRAM DATA
PROCÉDÉ ET DISPOSITIF D'ÉMISSION AVEC ADAPTATION DES DONNÉES DE CODAGE AUX DONNÉES DE PROGRAMME

(30) Priorität: 14.06.2007 DE 102007027432; 17.07.2007 DE 102007033266
(43) Veröffentlichungstag der Anmeldung: 24.02.2010
(73) Patentinhaber: Rohde & Schwarz GmbH & Co. KG, 81671 München (DE)
(72) Erfinder: ZUREK-TERHARDT, Günther, 15566 Schöneiche (DE)
(74) Vertreter: Körfer, Thomas
(86) Internationale Anmeldenummer: PCT/EP2007/011085
(87) Internationale Veröffentlichungsnummer: WO 2008/151656

(56) Entgegenhaltungen:
- EP-A- 1 018 815
- WO-A-2006/123231

## Beschreibung

Die Erfindung betrifft ein Verfahren und eine Sendevorrichtung mit Adaption der Codierungsdaten an die Programmdaten, insbesondere in einem DVB-H-Übertragungs-system.

In einem digitalen Fernseh-Übertragungssystemen, insbesondere in einem Digital-Video-Broadcast-Handheld-Übertragungssysteme (DVB-H-Übertragungssystem) oder in einem Advanced-Television-Systems-Comittee-Übertragungssystem (ATSC-Übertragungssystem) werden die zu übertragenden Nutz- bzw. Programm-Daten nach einem Kanalcodierungsverfahren - beispielsweise mithilfe eines Reed-Solomon-Algorithmus - zur Erzielung eines optimalen Fehlerschutzes im Übertragungskanal verschlüsselt. Die dazu notwendigen Verschlüsselungs- oder Codierungs-Daten werden zusätzlich mit den codierten Nutz- bzw. Programm-Daten übertragen.

Zum technologischen Hintergrund sei z.B. auf die WO 2006/031925 A2 verwiesen.

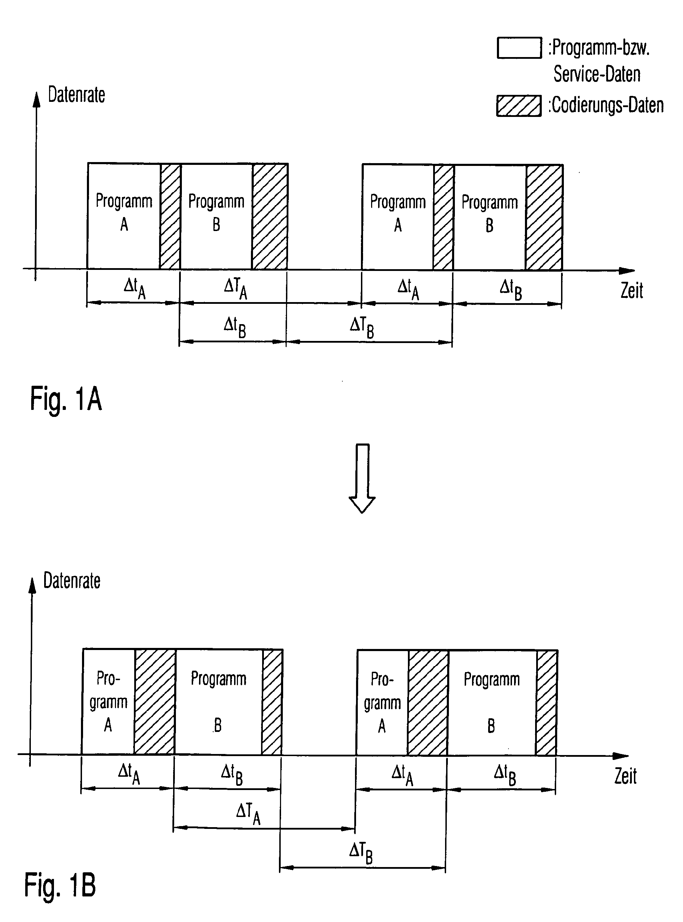

In einem DVB-H-oder ATSC-Übertragungssystem werden gemäß Fig. 1A die zu einem übertragenen Programm bzw. Service A, B usw. gehörigen Programm- bzw. Service-Daten zusammen mit den Codierungs-Daten in periodisch wiederholten, zum jeweiligen Programm bzw. Service A, B usw. gehörigen Burstintervallen der Länge Δ*t_{A}*, Δ*t_{B}* usw. übertragen. Zwischen den zum jeweils empfangenen Programm bzw. Service A, B usw. gehörigen Burstintervallen Δ*t_{A},* Δ*t_{B}* usw. während der Zeitintervale Δ*T_{A},* Δ*T_{B}* usw. werden die zum Empfang gehörigen Baugruppen des Mobilfunkgeräts ausgeschaltet und somit der Energieverbrauch des Mobilfunkgeräts reduziert.

Da die in einem Burstintervall zu übertragene Gesamtanzahl an Programm- bzw. Service-Daten und Codierungs-Daten näherungsweise konstant ist, ist im Hinblick auf einen höheren Fehlerschutz die Anzahl von Codierungs-Daten je Burstintervall im gleichen Maß zu erhöhen, wie die Anzahl von Programm- bzw. Service-Daten je Burstintervall zu reduzieren ist. Analog kann die Anzahl von Programm- bzw. Service-Daten bei gleichzeitiger Reduzierung der Anzahl von Codierungs-Daten im Hinblick auf einen niedrigeren Fehlerschutz erhöht werden. Diese adaptive Anpassung des Fehlerschutzes ist im DVB-H-Standard bereits üblich.

In Fig. 1B ist der Fall einer Erhöhung des Fehlerschutzes für Programm A und einer Reduzierung des Fehlerschutzes für Programm B dargestellt. Bei konstanter Länge des Burstintervalls Δ*t_{A},* Δ*t_{B}* für Programm bzw. Service A und B reduziert sich die Anzahl der Programm- bzw. Service-Daten für Progromm bzw. Service A bei gleichzeitiger Erhöhung der zugehörigen Codierungs-Daten und erhöht sich die Anzahl der Programm- bzw. Service-Daten für Programm bzw. Service B bei gleichzeitiger Reduzierung der zugehörigen Codierungs-Daten.

In der Praxis werden aber für unterschiedliche Dateninhalte - beispielsweise für Audio- und Video-Daten - unterschiedliche Anforderungen an den Fehlerschutz gestellt, die nach dem DVB-H- bzw. ATSC-Standard nicht vorgesehen sind. In einem solchen Fall werden alle Programmdaten eines Burstintervalls mit dem gleich hohen - dem höchst erforderlichen - Fehlerschutz nachteilig auf Kosten einer geringen Bandbreiteneffizienz codiert.

Aufgabe der Erfindung ist es deshalb, ein Verfahren und eine Sendevorrichtung in einem digitalen Fernseh-Übertragungssystem derart weiterzuentwickeln, dass für unterschiedliche Anforderungen an den Fehlerschutz bei einzelnen Programmdaten eines Programms eine optimierte Bandbreiteneffizienz erzielt wird.

Die Aufgabe wird bezüglich des Verfahrens durch die Merkmale des Anspruchs 1 und bezüglich der Sendevorrichtung durch die Merkmale des Anspruchs 10 gelöst. Die Unteransprüche enthalten vorteilhafte Weiterbildungen.

Hierzu werden die zu einem Programm bzw. Service gehörigen Programm- bzw. Service-Daten in Untermengen von Programm- bzw. Service-Daten geteilt, wobei jede Untermenge Programm- bzw. Service-Daten mit gleichen oder näherungsweise gleichen Anforderungen an den Fehlerschutz aufweist. Für jede dieser Untermengen ist jeweils ein individuelles Verhältnis der Anzahl von Programm- bzw. Service-Daten zur Anzahl von zugehörigen Codierungs-Daten - sogenannte Codierungsrate - einstellbar, wobei bei Änderung eines oder mehrerer dieser Verhältnisse die Länge des zum jeweiligen Programm bzw. Service gehörigen Burstintervalls konstant zu halten ist.

Bei den einzelnen Untermengen von Programm- bzw. Service-Daten kann es sich um die zu einem Programm bzw. Service gehörigen Audio- und Video-Daten handeln.

Alternativ können sich die Untermengen von Programm- und Service-Daten auch aus Programm- bzw. Service-Daten mit hoch relevanten und mit niedrig relevanten Programminhalten - beispielsweise aus Videodaten mit inhaltlichen Veränderungen in der Videosequenz und Videodaten mit unveränderten Inhalten in der Videosequenz - zusammensetzen.

In einer ersten Ausführungsform des erfindungsgemäßen Verfahrens und der erfindungsgemäßen Sendevorrichtung bleibt bei einer Änderung des Verhältnisses der Anzahl von Programm- bzw. Service-Daten zur Anzahl von zugehörigen Codierungs-Daten von mindestens einer Untermenge von Programm- bzw. Service-Daten das Verhältnis der Anzahl von zu den einzelnen Untermengen jeweils gehörigen Programm- bzw. Service- und Codierungsdaten je Burstintervall konstant.

In einer zweiten Ausführungsform des erfindungsgemäßen Verfahrens und der erfindungsgemäßen Sendevorrichtung ändert sich bei einer Änderung des Verhältnisses der Anzahl von Programm- bzw. Service-Daten zur Anzahl von zugehörigen Codierungs-Daten von mindestens einer Untermenge von Programm- bzw. Service-Daten das Verhältnis der Anzahl von zu den einzelnen Untermengen jeweils gehörigen Programm- bzw. Service- und Codierungs-Daten je Burstintervall zwischen den einzelnen Untermengen.

In einer dritten Ausführungsform des erfindungsgemäßen Verfahrens und der erfindungsgemäßen Sendevorrichtung sind die einzelnen Untermengen von Programm- und Service-Daten und zugehörigen Codierungs-Daten eines Programms bzw. Services in einem einzigen zum jeweiligen Programm bzw. Service gehörigen Burstintervall angeordnet.

In einer vierten Ausführungsform des erfindungsgemäßen Verfahrens und der erfindungsgemäßen Sendevorrichtung sind die Programm- bzw. Service-Daten und zugehörigen Codierungs-Daten für mehrere Untermengen von Programm- und Service-Daten in jeweils einem gemeinsamen, zur jeweiligen Gruppe von Untermengen gehörigen Burstintervall angeordnet.

In einer fünften Ausführungsform des erfindungsgemäßen Verfahrens und der erfindungsgemäßen Sendevorrichtung sind die Programm- bzw. Service-Daten und zugehörigen Codierungs-Daten für jede Untermenge von Programm- und Service-Daten in jeweils einem einzigen zum jeweiligen Programm bzw. Service gehörigen Burstintervall angeordnet.

Die einzelnen Ausführungsformen des erfindungsgemäßen Verfahrens und der erfindungsgemäßen Sendevorrichtung mit Adaption der Codierungsdaten an die Programmdaten in einem digitalen Fernseh-Übertragungssystem werden im Folgenden im Detail anhand der Zeichnung erläutert. Die Figuren der Zeichnung zeigen:
- Fig. 1A, 1B: ein bisher übliches Datenrate-Zeit-Diagramm einer digitalen Fernseh-Übertragung mit adaptiven Fehlerschutz vor bzw. nach Änderung der Codierungsrate,
- Fig. 2A, 2B: ein Datenrate-Zeit-Diagramm einer ersten Ausführungsform einer erfindungsgemäßen Anpassung der Codierungs-Daten an dieProgramm-Daten in einer digitalen Fernseh-Übertragung vor bzw. nach Änderung der Codierungsrate,
- Fig. 2C: ein Datenrate-Zeit-Diagramm einer zweiten Ausführungsform einer erfindungsgemäßen Anpassung der Codierungs-Daten an die Programm-Daten in einer digitalen Fernseh-Übertragung nach Änderung der Codierungs rate,
- Fig. 3A, 3D: ein Datenrate-Zeit-Diagramm einer dritten Ausführungsform einer erfindungsgemäßen Anpassung der Codierungs-Daten an die Programm-Daten in einer digitalen Fernseh-Übertragung vor bzw. nach Änderung der Codierungsrate,
- Fig. 3B, 3E: ein Datenrate-Zeit-Diagramm einer vierten Ausführungsform einer erfindungsgemäßen Anpassung der Codierungs-Daten an die Programm-Daten in einer digitalen Fernseh-Übertragung vor bzw. nach Änderung der Codierungsrate und
- Fig. 3C, 3F: ein Datenrate-Zeit-Diagramm einer fünften Ausführungsform einer erfindungsgemäßen Anpassung der Codierungs-Daten an die Programm-Daten in einer digitalen Fernseh-Übertragung vor bzw. nach Änderung der Codierungsrate.

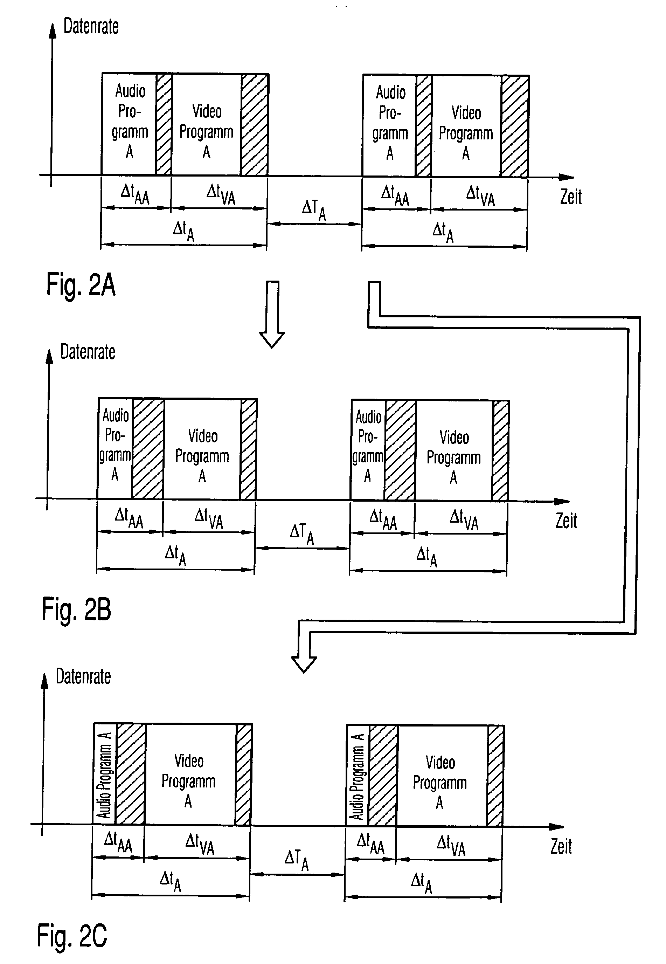

Im Datenrate-Zeit-Diagramm des erfindungsgemäßen Verfahrens und der erfindungsgemäßen Sendevorrichtung gemäß Fig. 2A bis 2C ist in Abgrenzung zum bisher üblichen Vorgehen für jede Untermenge von Programm- bzw. Service-Daten ein separater Fehlerschutz vorgesehen. In der ersten Ausführungsform der Fig. 2B wie auch in der zweiten Ausführungsform der Fig. 2C werden als Untermengen der Programm- bzw. Service-Daten die Audio-Daten und die Video-Daten der Programme bzw. Service A und B beispielhaft verwendet. Die Länge Δ*t_{A}* des Burstintervalls für Programm und Service A unterteilt sich folglich in ein Burstteilintervall der Länge Δ*t_{AA}* für Audio-Daten des Programms bzw. Services A und in ein Burstteilintervall der Länge Δ*t_{VA}* für Video-Daten des Programms bzw. Services A.

Im Datenrate-Zeit-Diagramm der ersten Ausführungsform des erfindungsgemäßen Verfahrens und der erfindungsgemäßen Sendevorrichtung gemäß Fig. 2B wird der Fehlerschutz für die Audio-Daten des Programms bzw. Service A erhöht und gleichzeitig der Fehlerschutz für die Video-Daten des Programms bzw. Services B reduziert. Die Änderung des Fehlerschutzes erfolgt bei konstanten Verhältnis der zu den Audio- und Video-Daten des Programms bzw. Services A jeweils gehörigen Programm- bzw. Service-Daten und Codierungs-Daten zwischen den Audio- und Video-Daten des Programms bzw. Services A. Somit sind die Längen Δ*t_{AA}* und Δ*t_{VA}* der Burstteilintervalle für die Audio- und Video-Daten des Programms bzw. Services A nach der Änderung des Fehlerschutzes in Fig. 2B gegenüber vor der Änderung des Fehlerschutzes in Fig. 2A konstant. Die für Programm bzw. Service A vorgesehene Länge Δ*t_{A}* des Burstintervalls bleibt während der Änderung des Fehlerschutzes konstant.

Auf diese Weise ist es möglich, die Übertragung der Audio-Daten des Programms bzw. Services A stärker zu schützen, während für die Übertragung der Video-Daten des Programms bzw. Services A ein geringerer Fehlerschutz vollkommen ausreichend ist. Das Audiosignal wird folglich vollkommen störungsfrei übertragen, während im Videosignal Aussetzer, Ruckler und sonstige Störungen in Kauf genommen werden. Aufgrund des geringeren Fehlerschutzes für Videosignale können vorteilhaft mehr Video-Daten pro Zeiteinheit beispielsweise zur Erzielung einer höheren Auflösung pro übertragenen Bild übertragen werden.

Im Datenrate-Zeit-Diagramm der zweiten Ausführungsform des erfindungsgemäßen Verfahrens und der erfindungsgemäßen Sendevorrichtung gemäß Fig. 2C wird der Fehlerschutz für die Audio-Daten des Programms bzw. Service A erhöht und gleichzeitig der Fehlerschutz für die Video-Daten des Programms bzw. Services B reduziert. Die Änderung des Fehlerschutzes erfolgt gleichzeitig mit geändertem Verhältnis der zu den Audio- und Video-Daten des Programms bzw. Services A jeweils gehörigen Programm- bzw. Service-Daten und Codierungs-Daten zwischen den Audio- und Video-Daten des Programms bzw. Services A. Die Länge Δ*t_{AA}* des Burstteilintervalls für die Audio-Daten des Programms bzw. Services A nach der Änderung des Fehlerschutzes in Fig. 2C ist gegenüber vor der Änderung des Fehlerschutzes in Fig. 2A reduziert, während die Länge Δ*t_{VA}* des Burstteilintervalls für die Video-Daten des Programms bzw. Services A nach der Änderung des Fehlerschutzes in Fig. 2C gegenüber vor der Änderung des Fehlerschutzes in Fig. 2A erhöht ist. Auf diese Weise kann das Datenvolumen für das Videosignal pro Zeiteinheit gegenüber der Situation in der ersten Ausführungsform zusätzlich noch erhöht werden. Die für Programm bzw. Service A vorgesehene Länge Δ*t_{A}* des Burstintervalls bleibt während der Änderung des Fehlerschutzes analog zur ersten Ausführungsform konstant.

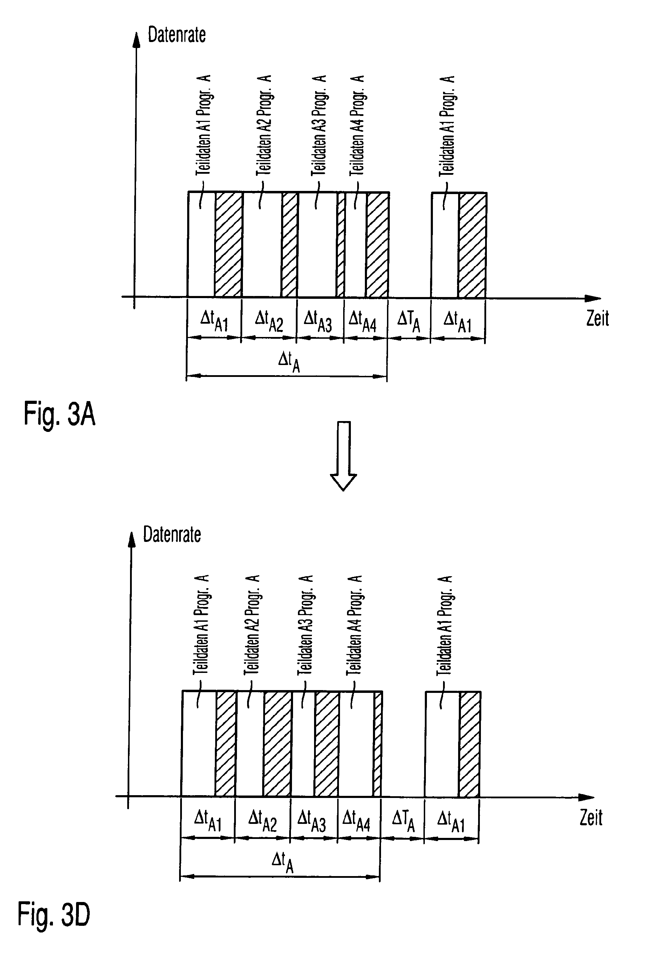

Im Datenrate-Zeit-Diagramm des erfindungsgemäßen Verfahrens und der erfindungsgemäßen Sendevorrichtung in Fig. 3A bis 3F werden als Untermengen des Programms bzw. Sevices A bestimmte Teildatenbereiche A1, A2, A3 und A4 bestimmt, für die unterschiedliche Codierungsraten im Hinblick auf einen unterschiedlichen Fehlerschutz ausgewählt werden.

Bei den einzelnen Teildatenbereichen A1, A2, A3 und A4 handelt es sich beispielsweise um Datenbereiche mit unterschiedlich relevanten Dateninhalten, für deren Übertragung unterschiedliche Anforderungen an die Übertragungsqualität gestellt werden.

In der dritten, vierten und fünften Ausführungsform des erfindungsgemäßen Verfahrens und der erfindungsgemäßen Sendevorrichtung wird das Verhältnis der Anzahl von Programm- bzw. Service-Daten zur Anzahl der zugehörigen Codierungs-Daten - die Codierungsrate - bei den Teildaten A1 des Programms bzw. Services A reduziert, bei den Teildaten A2 des Programms bzw. Services A erhöht, bei den Teildaten A3 des Programms bzw. Services A erhöht und bei den Teildaten A4 des Programms bzw. Services A reduziert, wobei das Verhältnis der Längen Δ*t*_{*A*1}, Δ*t*_{*A*2}*,* Δ*t*_{*A*3} und Δ*t*_{*A*4} der Burstteilintervalle der Teildaten A1, A2, A3 und A4 des Programms bzw. Services A vor und nach der Änderung der Codierungsrate jeweils konstant bleibt (analog zur ersten Ausführungsform des erfindungsgemäßen Verfahrens und der erfindungsgemäßen Sendevorrichtung).

In der dritten Ausführungsform des erfindungsgemäßen Verfahrens und der erfindungsgemäßen Sendevorrichtung in Fig. 3A vor Änderung der Codierungsrate und in Fig. 3D nach Änderung der Codierungsrate werden die Teildaten A1, A2, A3 und A4, bestehend aus Programm- bzw. Service-Daten sowie den dazugehörigen Codierungs-Daten des Programms bzw. Services A, in einem einzigen Burstintervall der Länge Δ*t_{A}* übertragen.

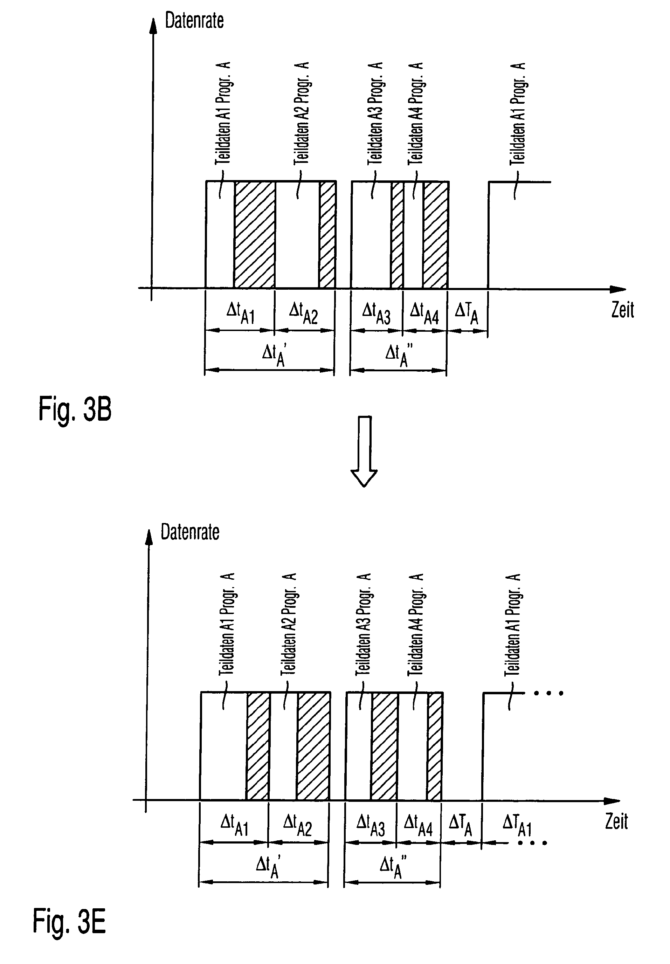

In der vierten Ausführungsform des erfindungsgemäßen Verfahrens und der erfindungsgemäßen Sendevorrichtung in Fig. 3B vor Änderung der Codierungsrate und in Fig. 3E nach Änderung der Codierungsrate werden die Teildaten A1 und A2, bestehend aus Programm- bzw. Service-Daten sowie den dazugehörigen Codierungs-Daten des Programms bzw. Services A, in einem Burstintervall der Länge Δ*t_{A}'* und die Teildaten A3 und A4, bestehend aus Programm- bzw. Service-Daten sowie den dazugehörigen Codierungs-Daten des Programms bzw. Services A, in einem Burstintervall der Länge Δ*t_{A}^{''}* übertragen.

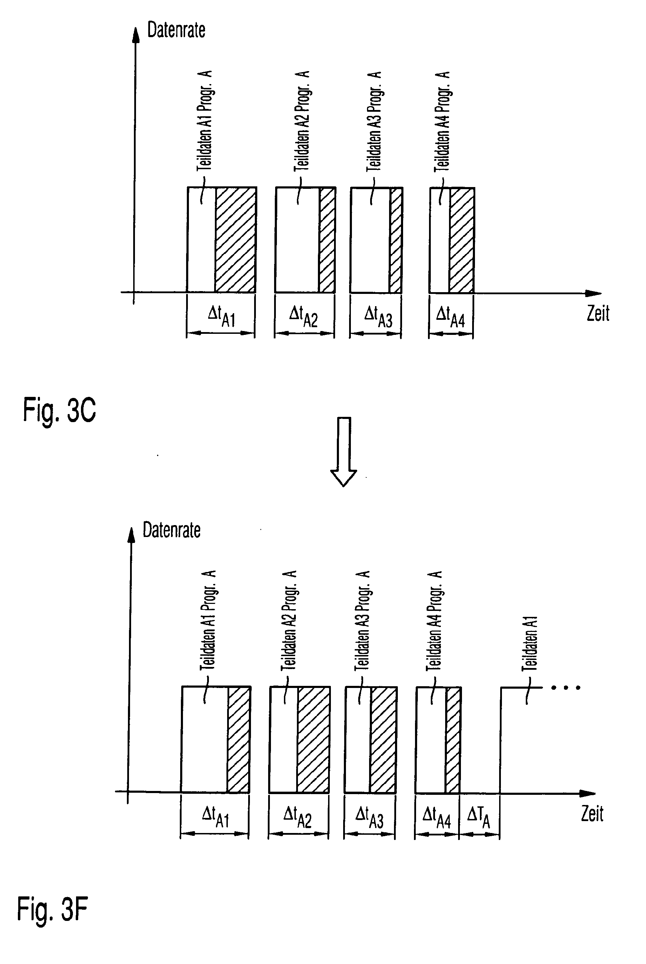

In der fünften Ausführungsform des erfindungsgemäßen Verfahrens und der erfindungsgemäßen Sendevorrichtung in Fig. 3C vor Änderung der Codierungsrate und in Fig. 3F nach Änderung der Codierungsrate werden alle Teildaten A1, A2, A3 und A4, bestehend aus Programm- bzw. Service-Daten sowie den dazugehörigen Codierungs-Daten des Programms bzw. Services A, jeweils in einem separaten Burstintervall der Längen Δ*t*_{*A*1}, Δ*t*_{*A*2}*,* Δ*t*_{*A*3} und Δ*t*_{*A*4} übertragen.

Insbesondere die vierte und fünfte Ausführungsform des erfindungsgemäßen Verfahrens und der erfindungsgemäßen Sendevorrichtung ermöglicht, die einzelnen Teildaten oder einzelnen Gruppen von Teildaten in einer unterschiedlich großen Periodizität abhängig von jeweiligen Datenvolumen und/oder von den jeweiligen vom Programm- bzw. Service-Inhalt abhängigen Aktualisierungsanforderungen zu übertragen.

Die Erfindung ist nicht auf die dargestellten Ausführungsformen beschränkt. Insbesondere sind von der Erfindung alle möglichen Kombinationen der einzelnen Ausführungsformen und auch vom DVB-H- oder ATSC-Übertragungsstandard verschiedene Übertragungsstanddards der digitalen Fernseh-Übertragung, insbesondere zukünftig zum Einsatz kommende Übertragungsstandards, abgedeckt.

## Patentansprüche

1. Verfahren zur Übertragung von Programm- bzw. Service-Daten und von Codierungs-Daten zur Codierung des Fehlerschutzes der Programm- bzw. Service-Daten in periodisch wiederholten, zum jeweiligen Programm bzw. Service (A,B) gehörigen Burstintervallen in einem digitalen Fernseh-Übertragungssystem, wobei das Verhältnis der Anzahl der zum jeweiligen Programm bzw. Service (A,B) gehörigen Programm- bzw. Service-Daten zur Anzahl der zugehörigen Codierungs-Daten einstellbar ist und die zu den einzelnen Programmen bzw. Services (A,B) jeweils gehörigen Programm- bzw. Service-Daten jeweils in mehrere Untermengen von Programm- bzw. Service-Daten einteilbar sind,
wobei für jede Untermenge jeweils ein unterschiedliches Verhältnis der Anzahl von Programm- bzw. Service-Daten zur Anzahl der zugehörigen Codierungs-Daten bei konstanter Länge (Δ*t_{A} ;* Δ*t_{A}^{'},* Δ*t_{A}^{''};* Δ*t*_{*A*1}*,* Δ*t*_{*A*2}, Δ*t*_{*A*2}*,* Δ*t*_{*A*4}) des zum jeweiligen Programm bzw. Service (A,B) gehörigen Burstintervalls einstellbar sind,
**dadurch gekennzeichnet,**
**dass** die Länge (Δ*t_{AA},*Δ*t_{VA}*) eines Burstteilintervalls für jede Untermenge nach einer Änderung des Fehlerschutzes gegenüber vor der Änderung des Fehlerschutzes geändert wird.

2. Verfahren zur Übertragung von Programm- bzw. Service-Daten und von Codierungs-Daten nach Anspruch 1,
**dadurch gekennzeichnet,**
**dass** das digitale Fernsehübertragungssystem ein nach dem Digital-Video-Broadcast-Handheld-Übertragungsstandard (DVB-H) oder ein nach dem Advanced-Telvision-Systems-Comittee-Übertragungsstandard (ATSC) ausgerichtetes digitales Fernsehübertragungssystem ist.

3. Verfahren zur Übertragung von Programm- bzw. Service-Daten und von Codierungs-Daten nach Anspruch 1 oder 2,
**dadurch gekennzeichnet,**
**dass** die Untermengen von Programm- bzw. Service-Daten die zum jeweiligen Programm bzw. Service (A,B) gehörigen Audio- und Video-Daten sind.

4. Verfahren zur Übertragung von Programm- bzw. Service-Daten und von Codierungs-Daten nach Anspruch 1 oder 2,
**dadurch gekennzeichnet,**
**dass** die Untermengen von Programm- bzw. Service-Daten die zum jeweiligen Programm bzw. Service (A,B) gehörigen hoch relevanten Datenanteile und niedrig relevanten Datenanteile sind.

5. Verfahren zur Übertragung von Programm- bzw. Service-Daten und von Codierungs-Daten nach einem der Ansprüche 1 bis 4,
**dadurch gekennzeichnet,**
**dass** bei Änderung des Verhältnisses der Anzahl von Programm- bzw. Service-Daten zur Anzahl der zugehörigen Codierungs-Daten das Verhältnis der Anzahl von zu den einzelnen Untermengen jeweils gehörigen Programm- bzw. Service- und Codierungs-Daten je Burstintervall zwischen den einzelnen Untermengen konstant bleibt.

6. Verfahren zur Übertragung von Programm- bzw. Service-Daten und von Codierungs-Daten nach einem der Ansprüche 1 bis 4,
**dadurch gekennzeichnet,**
**dass** sich bei Änderung des Verhältnisses der Anzahl von Programm- bzw. Service-Daten zur Anzahl der zugehörigen Codierungs-Daten das Verhältnis der Anzahl von zu den einzelnen Untermengen jeweils gehörigen Programm- bzw. Service- und Codierungsdaten je Burstintervall zwischen den einzelnen Untermengen ändert.

7. Verfahren zur Übertragung von Programm- bzw. Service-Daten und von Codierungs-Daten nach einem der Ansprüche 1 bis 6,
**dadurch gekennzeichnet,**
**dass** die Untermengen von Programm- bzw. Service-Daten und zugehörigen Codierungs-Daten in jeweils einem einzigen, periodisch wiederholten Burstintervall angeordnet sind.

8. Verfahren zur Übertragung von Programm- bzw. Service-Daten und von Codierungs-Daten nach einem der Ansprüche 1 bis 6,
**dadurch gekennzeichnet,**
**dass** mehrere Untermengen von Programm- bzw. Service-Daten und zugehörigen Codierungs-Daten in jeweils einem gemeinsamen, periodisch wiederholten Burstintervall angeordnet sind.

9. Verfahren zur Übertragung von Programm- bzw. Service-Daten und von Codierungs-Daten nach einem der Ansprüche 1 bis 6,
**dadurch gekennzeichnet,**
**dass** jede Untermenge von Programm- bzw. Service-Daten und zugehörigen Codierungs-Daten in jeweils einem einzigen, periodisch wiederholten Burstintervall angeordnet ist.

10. Sendevorrichtung zur Übertragung von Programm- bzw. Service-Daten und von Codierungs-Daten zur Codierung des Fehlerschutzes der Programm- bzw. Service-Daten in periodisch wiederholten, zum jeweiligen Programm bzw. Service (A,B) gehörigen Burstintervallen in einem digitalen Fernseh-Übertragungssystem, wobei das Verhältnis der Anzahl der zum jeweiligen Programm bzw. Service (A,B) gehörigen Programm- bzw. Service-Daten zur Anzahl der zugehörigen Codierungs-Daten einstellbar ist und die zu den einzelnen Programmen bzw. Services (A,B) jeweils gehörigen Programm- bzw. Service-Daten jeweils in mehrere Untermengen von Programm- bzw. Service-Daten einteilbar sind,
wobei für jede Untermenge jeweils ein unterschiedliches Verhältnis der Anzahl von Programm- bzw. Service-Daten zur Anzahl der zugehörigen Codierungs-Daten bei konstanter Länge (Δ*t_{A} ;* Δ*t_{A}^{'},* Δ*t_{A}^{''},* Δ*t*_{*A*1}, Δ*t*_{*A*2}, Δ*t*_{*A*3}, Δ*t*_{*A*4}) des zum jeweiligen Programm bzw. Service (A,B) gehörigen Burstintervalls einstellbar sind,
**dadurch gekennzeichnet,**
**dass** die Länge (Δ*t_{AA},*Δ*t_{VA}*) eines Burstteilintervalls für jede Untermenge nach einer Änderung des Fehlerschutzes gegenüber vor der Änderung des Fehlerschutzes geändert ist.

11. Sendevorrichtung zur Übertragung von Programm- bzw. Service-Daten und von Codierungs-Daten nach Anspruch 10,
**dadurch gekennzeichnet,**
**dass** das digitale Fernsehübertragungssystem ein nach dem Digital-Video-Broadcast-Handheld-Übertragungsstandard (DVB-H) oder ein nach dem Advanced-Telvision-Systems-Comittee-Übertragungsstandard (ATSC) ausgerichtetes digitales Fernsehübertragungssystem ist.

12. Sendevorrichtung zur Übertragung von Programm- bzw. Service-Daten und von Codierungs-Daten nach Anspruch 10 oder 11,
**dadurch gekennzeichnet,**
**dass** die Untermengen von Programm- bzw. Service-Daten die zum jeweiligen Programm bzw. Service (A,B) gehörigen Audio- und Video-Daten sind.

13. Sendevorrichtung zur Übertragung von Programm- bzw. Service-Daten und von Codierungs-Daten nach Anspruch 10 oder 11,
**dadurch gekennzeichnet,**
**dass** die Untermengen von Programm- bzw. Service-Daten die zum jeweiligen Programm bzw. Service (A,B) gehörigen hoch relevanten Datenanteile und niedrig relevanten Datenanteile sind.

14. Sendevorrichtung zur Übertragung von Programm- bzw. Service-Daten und von Codierungs-Daten nach einem der Ansprüche 10 bis 13,
**dadurch gekennzeichnet,**
**dass** bei Änderung des Verhältnisses der Anzahl von Programm- bzw. Service-Daten zur Anzahl der zugehörigen Codierungs-Daten für mindestens eine Untermenge das Verhältnis der Anzahl von zu den einzelnen Untermengen jeweils gehörigen Programm- bzw. Service- und Codierungsdaten je Burstintervall konstant bleibt.

15. Sendevorrichtung zur Übertragung von Programm- bzw. Ser-vice-Daten und von Codierungs-Daten nach einem der Ansprüche 10 bis 13,
**dadurch gekennzeichnet,**
**dass** sich bei Änderung des Verhältnisses der Anzahl von Programm- bzw. Service-Daten zur Anzahl der zugehörigen Codierungs-Daten für mindestens eine Untermenge das Verhältnis der Anzahl von zu den einzelnen Untermengen jeweils gehörigen Programm- bzw. Service- und Codierungsdaten je Burstintervall ändert.

16. Sendevorrichtung zur Übertragung von Programm- bzw. Service-Daten und von Codierungs-Daten nach einem der Ansprüche 10 bis 15,
**dadurch gekennzeichnet,**
**dass** die Untermengen von Programm- bzw. Service-Daten und zugehörigen Codierungs-Daten in jeweils einem einzigen, periodisch wiederholten Burstintervall angeordnet sind.

17. Sendevorrichtung zur Übertragung von Programm- bzw. Service-Daten und von Codierungs-Daten nach einem der Ansprüche 10 bis 15,
**dadurch gekennzeichnet,**
**dass** mehrere Untermengen von Programm- bzw. Service-Daten und zugehörigen Codierungs-Daten in jeweils einem gemeinsamen, periodisch wiederholten Burstintervall angeordnet sind.

18. Sendevorrichtung zur Übertragung von Programm- bzw. Service-Daten und von Codierungs-Daten nach einem der Ansprüche 10 bis 15,
**dadurch gekennzeichnet,**
**dass** jede Untermenge von Programm- bzw. Service-Daten und zugehörigen Codierungs-Daten in jeweils einem einzigen, periodisch wiederholten Burstintervall angeordnet ist.

## Claims

1. Method for the transmission of channel data and/or service data and coding data for coding the error protection of the channel and/or service data in periodically-repeated burst intervals associated with the respective channel and/or service (A,B) within a digital television transmission system, wherein the ratio of the number of channel and/or service data associated with each channel and/or service (A,B) relative to the number of associated coding data is adjustable, and the channel and/or service data associated with the individual channels and/or services (A,B) are each divisible into several subgroups of channel and/or service data,
wherein, for every subgroup, a different ratio of the number of channel and/or service data relative to the number of associated coding data can be adjusted with a constant length (Δt_{A}; Δt_{A}', Δt_{A}'' ; Δt_{A1}, Δt_{A2}, Δt_{A3}, Δt_{A4}) of the burst intervals associated with the respective channel and/or service (A,B),
**characterised in that**
the length (Δt_{AA}, Δt_{VA}) of a burst interval for each subgroup is changed after a change of error protection relative to before the change of error protection.

2. Method for the transmission of channel and/or service data and coding data according to claim 1,
**characterised in that**
the digital television transmission system is a digital television transmission system provided according to the Digital Video Broadcast Handheld transmission standard (DVB-H) or according to the Advanced Television Systems Committee transmission standard (ATSC).

3. Method for the transmission of channel and/or service data and coding data according to claim 1 or 2,
**characterised in that**
the subgroups of channel and/or service data are the audio and video data associated with the respective channel and/or service (A,B).

4. Method for the transmission of channel and/or service data and coding data according to claim 1 or 2,
**characterised in that**
the subgroups of channel and/or service data are the high-relevance data divisions and low-relevance data divisions associated with the respective channel and/or service (A,B).

5. Method for the transmission of channel and/or service data and coding data according to any one of claims 1 to 4,
**characterised in that,**
in the event of a change in the ratio of the number of channel and/or service data relative to the number of associated coding data, the ratio of the number of channel and/or service data and coding data associated with the individual subgroups per burst interval remains constant between the individual subgroups.

6. Method for the transmission of channel and/or service data and coding data according to any one of claims 1 to 4,
**characterised in that,**
in the event of a change in the ratio of the number of channel and/or service data relative to the number of associated coding data, the ratio of the number of channel and/or service data and coding data associated with the individual subgroups per burst interval changes between the individual subgroups.

7. Method for the transmission of channel and/or service data and coding data according to any one of claims 1 to 6,
**characterised in that**
the subgroups of channel and/or service data and associated coding data are arranged respectively in a single, periodically-repeated burst interval.

8. Method for the transmission of channel and/or service data and coding data according to any one of claims 1 6,
**characterised in that**
several subgroups of channel and/or service data and associated coding data are arranged respectively in a common, periodically-repeated burst interval.

9. Method for the transmission of channel and/or service data and coding data according to any one of claims 1 to 6,
**characterised in that**
each subgroup of channel and/or service data and associated coding data is arranged respectively in a single, periodically-repeated burst interval.

10. Transmission device for the transmission of channel and/or service data and coding data for coding the error protection of the channel and/or service data in periodically-repeated burst intervals associated with the respective channel and/or service (A,B) within a digital television transmission system, wherein the ratio of the number of channel and/or service data associated with each channel and/or service (A,B) relative to the number of associated coding data is adjustable, and the channel and/or service data associated with the individual channels and/or services (A,B) are respectively divisible into several subgroups of channel and/or service data, wherein, respectively for every subgroup, a different ratio of the number of channel and/or service data relative to the number of associated coding data can be adjusted with a constant length (Δt_{A}; Δt_{A}', Δt_{A}'' ; Δt_{A1}, Δt_{A2}, Δt_{A3}, Δt_{A4}) of the burst intervals associated with the respective channel and/or service (A, B),
**characterised in that**
the length (Δt_{AA}, Δt_{VA}) of a burst interval for each subgroup is changed after a change of error protection relative to before the change of error protection.

11. Transmission device for the transmission of channel and/or service data and coding data according to claim 10,
**characterised in that**
the digital television transmission system is a digital television transmission system orientated according to the Digital Video Broadcast Handheld transmission standard (DVB-H) or according to the Advanced Television Systems Committee transmission standard (ATSC).

12. Transmission device for the transmission of channel and/or service data and coding data according to claim 10 or 11,
**characterised in that**
the subgroups of channel and/or service data are the audio and video data associated with the respective channel and/or service (A,B).

13. Transmission device for the transmission of channel and/or service data and coding data according to claim 10 or 11,
**characterised in that**
the subgroups of channel and/or service data are the high-relevance data divisions and low-relevance data divisions associated with the respective channel and/or service (A, B).

14. Transmission device for the transmission of channel and/or service data and coding data according to any one of claims 10 to 13,
**characterised in that,**
in the event of a change in the ratio of the number of channel and/or service data relative to the number of associated coding data, for at least one subgroup, the ratio of the number of channel and/or service data and coding data associated with the individual subgroups per burst interval remains constant.

15. Transmission device for the transmission of channel and/or service data and coding data according to any one of claims 10 to 13,
**characterised in that,**
in the event of a change in the ratio of the number of channel and/or service data relative to the number of associated coding data, for at least one subgroup, the ratio of the number of channel and/or service data and coding data associated with the individual subgroups per burst interval changes.

16. Transmission device for the transmission of channel and/or service data and coding data according to any one of claims 10 to 15,
**characterised in that**
the subgroups of channel and/or service data and associated coding data are arranged respectively in a single, periodically-repeated burst interval.

17. Transmission device for the transmission of channel and/or service data and coding data according to any one of claims 10 to 15,
**characterised in that**
several subgroups of channel and/or service data and associated coding data are arranged respectively in a common, periodically-repeated burst interval.

18. Transmission device for the transmission of channel and/or service data and coding data according to any one of claims 10 to 15,
**characterised in that**
each subgroup of channel and/or service data and associated coding data is arranged respectively in a single, periodically-repeated burst interval.

## Revendications

1. Procédé de transmission de données de programme ou de service et de données de codage en vue de coder la protection contre des erreurs des données de programme ou de service dans des intervalles en rafale périodiquement répétés associés à un programme ou un service respectif (A, B) dans un système de transmission télévisée numérique, dans lequel le rapport du nombre de données de programme ou de service associées au programme ou au service respectif (A, B) peut être ajusté par rapport au nombre de données de codage associées et les données de programme ou de service respectivement associées aux différents programmes ou services (A, B) peuvent être réparties respectivement en plusieurs sous-ensembles de données de programme ou de service,
dans lequel, pour chaque sous-ensemble, un rapport différent respectif du nombre de données de programme ou de service par rapport au nombre de données de codage associées peut être ajusté dans le cas d'une longueur constante (Δt_{A} ; Δt_{A}', Δt_{A}" ; Δt_{A1}, Δt_{A2}, Δt_{A3}, Δt_{A4}) de l'intervalle en rafale associé au programme ou au service respectif (A, B),
**caractérisé en ce que**
la longueur (Δt_{AA}, Δt_{VA}) d'un intervalle partiel en rafale pour chaque sous-ensemble après une modification de la protection contre les erreurs est modifiée par contre avant la modification de la protection contre les erreurs.

2. Procédé de transmission de données de programme ou de service et de données de codage selon la revendication 1, **caractérisé en ce que**
le système de transmission télévisée numérique est un système de transmission télévisée numérique orienté selon le standard de transmission Digital-Video-Broadcast-Handheld (DVB-H) ou selon le standard de transmission Advanced-Television-Systems-Committee (ATSC).

3. Procédé de transmission de données de programme ou de service et de données de codage selon la revendication 1 ou 2, **caractérisé en ce que**
les sous-ensembles de données de programme ou de service sont les données audio et vidéo associées au programme ou au service respectif (A, B).

4. Procédé de transmission de données de programme ou de service et de données de codage selon la revendication 1 ou 2, **caractérisé en ce que**
les sous-ensembles de données de programme ou de service sont des ensembles de données très pertinentes et des ensembles de données peu pertinentes associés au programme ou au service respectif (A, B).

5. Procédé de transmission de données de programme ou de service et de données de codage selon l'une des revendications 1 à 4, **caractérisé en ce que**
lors de la modification du rapport du nombre de données de programme ou de service par rapport au nombre de données de codage associées, le nombre de données de programme ou de service et de données de codage respectives associées aux différents sous-ensembles à chaque intervalle en rafale reste constant entre les différents sous-ensembles.

6. Procédé de transmission de données de programme ou de service et de données de codage selon l'une des revendications 1 à 4, **caractérisé en ce que**
dans le cas d'une modification du rapport du nombre de données de programme ou de service par rapport au nombre de données de codage associées, le rapport du nombre de données de programme ou de service et de codage respectives associées aux différents sous-ensembles à chaque intervalle en rafale est modifié entre les différents sous-ensembles.

7. Procédé de transmission de données de programme ou de service et de données de codage selon l'une des revendications 1 à 6, **caractérisé en ce que**
les sous-ensembles de données de programme ou de service et de données de codage associées sont agencés dans un seul intervalle en rafale respectif périodiquement répété.

8. Procédé de transmission de données de programme ou de service et de données de codage selon l'une des revendications 1 à 6, **caractérisé en ce que**
plusieurs sous-ensembles de données de programme ou de service et de données de codage associées sont agencés dans un intervalle en rafale commun respectif périodiquement répété.

9. Procédé de transmission de données de programme ou de service et de données de codage selon l'une des revendications 1 à 6, **caractérisé en ce que**
chaque sous-ensemble de données de programme ou de données de service et de données de codage associées est agencé dans un seul intervalle en rafale respectif périodiquement répété.

10. Procédé d'émission en vue de la transmission de données de programme ou de service et de données de codage en vue du codage de la protection contre des erreurs des données de programme ou de service dans des intervalles en rafale périodiquement répétés associés au programme ou au service respectif (A, B) dans un système de transmission télévisée numérique, dans lequel le rapport du nombre de données de programme ou de service associées au programme ou au service respectif (A, B) par rapport au nombre de données de codage associées peut être ajusté et les données de programme ou de service respectives associées aux différents programmes ou services (A, B) peuvent être réparties dans plusieurs sous-ensembles respectifs de données de programme ou de service,
dans lequel, pour chaque sous-ensemble, un rapport différent respectif du nombre de données de programme ou de service par rapport au nombre de données de codage associées peut être ajusté dans le cas d'une longueur constante (Δt_{A} ; Δt_{A}', Δt_{A}" ; Δt_{A1}, Δt_{A2}, Δt_{A3}, Δt_{A4}) de l'intervalle en rafale associé au programme ou au service respectif (A, B),
**caractérisé en ce que**
la longueur (Δt_{AA}, Δt_{VA}) d'un intervalle partiel en rafale pour chaque sous-ensemble après une modification de la protection contre les erreurs est modifiée par contre avant la modification de la protection contre les erreurs.

11. Dispositif d'émission en vue de la transmission de données de programme ou de service et de données de codage selon la revendication 10, **caractérisé en ce que**
le système de transmission télévisée numérique est un système de transmission télévisée numérique orientée selon le standard de transmission Digital-Video-Broadcast-Handheld (DVB-H) ou selon le standard de transmission Advanced-Television-Systems-Committee (ATSC).

12. Dispositif d'émission en vue de la transmission de données de programme ou de service et de données de codage selon la revendication 10 ou 11, **caractérisé en ce que**
les sous-ensembles de données de programme ou de service sont des données audio et vidéo associées au programme ou au service respectif (A, B).

13. Dispositif d'émission en vue de la transmission de données de programme ou de service et de données de codage selon la revendication 10 ou 11, **caractérisé en ce que**
les sous-ensembles de données de programme ou de service sont des ensembles de données très pertinentes ou des ensembles de données peu pertinentes associées au programme ou au service respectif (A, B).

14. Dispositif d'émission en vue de la transmission de données de programme ou de service et de données de codage selon l'une des revendications 10 à 13, **caractérisé en ce que**
lors de la modification du rapport du nombre de données de programme ou de service par rapport au nombre de données de codage associées pour au moins un sous-ensemble, le rapport du nombre de données de programme ou de service et de codage respectives associées aux différents sous-ensembles reste constant à chaque intervalle en rafale.

15. Dispositif d'émission en vue de la transmission de données de programme ou de service et de données de codage selon l'une des revendications 10 à 13, **caractérisé en ce que**
lors de la modification du rapport du nombre de données de programme ou de service par rapport au nombre de données de codage associées pour au moins un sous-ensemble, le rapport du nombre de données de programme ou de service et de codage respectives associées aux différents sous-ensembles est modifié à chaque intervalle en rafale.

16. Dispositif d'émission en vue de la transmission de données de programme ou de service et de données de codage selon l'une des revendications 10 à 15, **caractérisé en ce que**
les sous-ensembles de données de programme ou de service et de données de codage associées sont agencés dans un seul intervalle en rafale respectif périodiquement répété.

17. Dispositif d'émission en vue de la transmission de données de programme ou de service et de données de codage selon l'une des revendications 10 à 15, **caractérisé en ce que**
plusieurs sous-ensembles de données de programme ou de service et de données de codage associées sont agencés dans un intervalle en rafale commun respectif périodiquement répété.

18. Dispositif d'émission en vue de la transmission de données de programme ou de service et de données de codage selon l'une des revendications 10 à 15, **caractérisé en ce que**
chaque sous-ensemble de données de programme ou de service et de données de codage associées est agencé dans un seul intervalle en rafale respectif périodiquement répété.
